# EUROPEAN PATENT APPLICATION

(11) **EP 1 898 239 A1**
(43) Date of publication of application: **12.03.2008**
(21) Application number: 06747225.8
(22) Date of filing: 01.06.2006
(51) Int. Cl.: G02B 5/30, G02F 1/1335, G02F 1/13363

(54) **CIRCULAR POLARIZING PLATE, METHOD FOR PRODUCING THE SAME, OPTICAL FILM, LIQUID CRYSTAL DISPLAY, AND ELECTROLUMINESCENT ELEMENT**

(30) Priority: 23.06.2005 JP 2005183822
(71) Applicant: Nippon Oil Corporation, Tokyo 105-8412 (JP)
(72) Inventor: UESAKA, Tetsuya, c/o NIPPON OIL CORPORATION, Yokohama-shi, Kanagawa 231-0815 (JP); NISHIMURA, Suzushi, c/o NIPPON OIL CORPORATION, Yokohama-shi, Kanagawa 231-0815 (JP)
(74) Representative: Grünecker, Kinkeldey, Stockmair & Schwanhäusser Anwaltssozietät
(86) International application number: PCT/JP2006/311465
(87) International publication number: WO 2006/137268

(57) **Abstract**

The present invention provides a circular polarizer, comprising at least an optically anisotropic element, a transmissive protection film and a polarizing element sandwiched therebetween, the optically anisotropic element comprising a liquid crystal layer aligned on a cellulose triacetate film and having a retardation of approximately 1/4 wavelength in the visible light region, the liquid crystal layer comprising a liquid crystal film with a fixed twisted nematic alignment. The circular polarizer is suppressed in thickness by simplifying the layer structure without causing defects such as peeling off the layers even under elevated temperature and humidity condition and makes it possible to set arbitrarily the angle of the alignment axis direction of the optically anisotropic element comprising a liquid crystal layer with a fixed twisted alignment with respect to the absorption axis of the polarizing element so that the optically anisotropic element and polarizing element both in the form of an elongate film can be laminated continuously to one another.

## Description

### [Field of the Invention]

The present invention relates to circular polarizers comprising a liquid crystal film with a fixed twisted nematic alignment, processes for producing such circular polarizers, optical films comprising such circular polarizers and further to liquid crystal display devices comprising such circular polarizers or optical films and electroluminescence devices (hereinafter referred to as "EL device") used in self-luminous flat display devices as well as in various illuminants or lighting units, in particular organic EL devices with excellent visibility, comprising such circular polarizers or optical films.

### [Background of the Invention]

Circular polarizers have been used for enhancing the image quality of liquid crystal display devices or organic EL devices and thus have taken industrially important roles.

For example, the application of a circular polarizer to a liquid crystal display device will be described.

Liquid crystal display devices are known to be classified into a transmissive liquid crystal display device which comprises a pair of linear polarizers and a liquid crystal cell sandwiched therebetween and displays images using a backlight and a reflective liquid crystal display device in which a reflector is arranged instead of a backlight so as to display images using external light. Alternatively, as a liquid crystal display device which can provide reflection images the outdoors and excellent transmission images under dark indoor conditions, a transflective liquid crystal display device has been proposed in which a liquid crystal cell containing therein a transflector that transmits a part of incident light is sandwiched between a pair of linear polarizers and a back light is arranged (Patent Document 1). This display device is used as a reflective device (reflection mode) when the backlight is off and as a transmissive device (transmission mode) with the back light is on under dark conditions.

This transflective liquid crystal display device uses one sheet of polarizer to display images in the reflection mode and two sheets of polarizers to display images in the transmission mode and thus needs to allow a circularly polarized light to make incident to the liquid crystal cell. As the result, it is necessary to arrange retardation films between the both polarizers and the liquid crystal cell.

Next, the application of a circular polarizer to an organic EL device will be described.

Vigorous studies and developments have been carried out for using an EL device wherein an illuminant layer is arranged between electrodes and illumination occurs upon application of an electric voltage thereto, as various light sources such as flat-type lighting units, those for optic fibers, back lights for liquid crystal displays and liquid crystal projectors, and light sources for other display devices. In particular, an organic EL device is excellent in illumination efficiency, low-voltage drivability, light weight and low production cost and thus has recently been considered to be a significantly attractive device.

The EL device is a device which injects electrons and holes from a cathode and an anode, respectively such that the electrons and holes are re-coupled in an illuminant layer thereby illuminating a visible light correspondingly to the illumination characteristics of the illuminant layer. ITO has been preferably used as the anode because it is highest in electric conductivity among currently eligible transparent electrically conductive materials and relatively larger in work function and can provide high hole injection efficiency. Although the cathode may be any metal electrode, materials such as Mg, MgAg, MgIn, Al and LiAl have been used as the cathode, taking account of electron injection efficiency in view of work function. These metal materials are high in light reflectivity and thus has a function to reflect a light illuminated in the illuminant layer so as to enhance the exit light intensity (luminance) in addition to the function as an electrode (cathode). That is, a light emitted to the direction of the cathode is specularly reflected at the surface of the metal material that is the cathode and then exits through the transparent ITO electrode (anode).

The organic EL device with such a structure has a cathode which is specular with strong light reflectivity and thus provides extremely remarkable external light reflections when the device does not emit light. That is, the organic EL device has crucial problems that it is too low in living contrast to be used as a light source for a display device because it excessively reflects room lighting on its specular surface and thus fails to display black color in a bright place.

However, taking advantage that the cathode of the EL device is a flat and smooth specular surface, external light can be significantly prevented from reflecting at the cathode by arranging a circular polarizer. The use of a circular polarizer for preventing the reflection of external light at a specular surface has been already known, and the use of a circular polarizer in an organic EL device has also been known (Patent Document Nos. 2 and 3).

It is known that a circular polarizer is generally produced by laminating a polarizer and a retardation film having a retardation of 1/4 wavelength in the visible light region. However, there are problems that the circular polarizer is increased in thickness by the portion of a tacky adhesive layer used for laminating a polarizer and a retardation film, which tacky adhesive layer will decrease the amount of the circular polarizer per roll when it is rolled up in the form of roll during the production, leading to a poor productivity and will increase the thickness of the resulting liquid crystal panel. Further, the circular polarizer has disadvantages that peeling off between the interfaces of the polarizer and the retardation film occurs under elevated temperature or humidity conditions because the circular polarizer is constructed by different layers that vary in their expansion and contraction behavior caused by heat or humidity. Conventionally, most of the retardation films comprise a polymer film produced by uniaxially stretching and aligning polycarbonate or the like in an elongate form and the alignment axis of the elongate film is usually limited to the direction of stretching, i.e., machine direction (MD). More specifically, the degree of freedom of the optical characteristics of the stretch-aligned retardation film is limited because it is difficult to control the alignment of the polymer at will. On the other hand, the polarizer is also formed of a uniaxially stretched film such as of polyvinyl alcohol and the absorption axis thereof in an elongate form is usually limited to the machine direction (MD). Therefore, the production of a circular polarizer by continuously laminating an elongate polarizer and an elongate retardation film is limited to a special case wherein the absorption axis of the polarizer is parallel to the alignment axis of the retardation film.

Generally, when a circular polarizer is produced by combining an absorption type linear polarizer and a 1/4 wavelength plate formed of a uniaxially stretched film, it is necessary to laminate them so that their optical axes cross to each other at an angle of 45 or 135 degrees. However, in order to arrange the axes at a cross angle of 45 or 135 degrees, which is other than parallel, the polarizer and the retardation film each in an elongate form must be cut into sheets to be laminated, causing problems that the production steps becomes complicated and the productivity becomes poor. As described above, a demand to a circular polarizer that has variations in arrangement of the absorption axis of the polarizer and the alignment axis of the retardation film and excellent optical properties has not been met sufficiently.

Patent Document Nos. 4 and 5 propose an optically anisotropic element wherein a liquid crystalline polymer compound is aligned and fixed. Further, Patent Document Nos. 6 and 7 propose a 1/4 wavelength plate formed of a liquid crystal film with a fixed twisted nematic alignment. The use of such liquid crystalline polymers can adjust the alignment axis at any angle and thus makes it possible to produce various circular polarizers by continuously laminating these polymers in the form of an elongate film. However, these circular polarizers still had defects as described above, i.e., increased thickness of the polarizers and peeling off at the interface between the polarizer and the optically anisotropic element at elevated temperatures and humidity.
Patent Document No. 1: Japanese Patent Laid-Open Publication No. 10-206846
Patent Document No. 2: Japanese Patent Laid-Open Publication No. 8-321381
Patent Document No. 3: Japanese Patent Laid-Open Publication No. 9-127885
Patent Document No. 4: Japanese Patent Laid-Open Publication No. 4-57017
Patent Document No. 5: Japanese Patent Laid-Open Publication No. 6-242317
Patent Document No. 6: Japanese Patent Laid-Open Publication No. 2002-48917
Patent Document No. 7: Japanese Patent Laid-Open Publication No. 2004-309904

### [Disclosure of the Invention]

The present invention has an object to provide a circular polarizer which is suppressed in thickness by simplifying the layer structure and free from defects such as peeling off at elevated temperatures and humidity and can be produced by continuously laminating an elongate film-like polarizer and an elongate film-like optically anisotropic element comprising a liquid crystal layer with a fixed twisted nematic alignment, the alignment axis of which optically anisotropic element is set at any angle with respect to the absorption axis of the polarizer; a process for producing the circular polarizer; an optical film comprising the circular polarizer; and an liquid crystal display device and an organic EL device used in a self-luminous flat display and various illuminants and lighting units, each comprising the circular polarizer.

That is, according to a first aspect of the present invention, there is provided a circular polarizer comprising at least an optically anisotropic element, a transmissive protection film and a polarizing element sandwiched therebetween, the optically anisotropic element comprising a liquid crystal layer aligned on a cellulose triacetate film and having a retardation of approximately 1/4 wavelength in the visible light region, the liquid crystal layer comprising a liquid crystal film with a fixed twisted nematic alignment.

According to a second aspect of the present invention, there is provided the circular polarizer of the first aspect, wherein the product of the birefringence Δn with respect to 550 nm wavelength light and the thickness d (nm) of the liquid crystal film is set within not less than 140nm and not greater than 300 nm, and the twisted angle is set within not smaller than 30 degrees and not greater than 85 degrees.

According to a third aspect of the present invention, there is provided the circular polarizer of the second aspect, wherein the combination of the product of the birefringence Δn with respect to 550 nm wavelength light and the thickness d (nm) and the twisted angle of the liquid crystal film is set to satisfy any of the following conditions:
(1) not less than 155 nm and not greater than 175 nm, and not smaller than 40 degrees and not greater than 50 degrees;
(2) not less than 176 nm and not greater than 216 nm, and not smaller than 58 degrees and not greater than 70 degrees; and
(3) not less than 230nm and not greater than 270 nm, and not smaller than 70 degrees and not greater than 80 degrees.

According to fourth aspect of the present invention, there is provided the circular polarizer of any one of the first to third aspects, wherein the liquid crystal film is a liquid crystal film produced by allowing a liquid crystal material in a liquid crystal state to be aligned in a twisted nematic alignment and cooling the material as it is so that the alignment is fixed in a glassy state.

According to a fifth aspect of the present invention, there is provided the circular polarizer of any one of the first to third aspects, wherein the liquid crystal film is a liquid crystal film produced by allowing a liquid crystal material in a liquid crystal state to be aligned in a twisted nematic alignment and fixing the alignment by crosslinking reaction with light or heat.

According to a sixth aspect of the present invention, there is provided the circular polarizer of any one of the first to fifth aspects, wherein the thickness thereof is 250 µm or less.

According to a seventh aspect of the present invention, there is provided the circular polarizer of any one of the first to sixth aspects, wherein the optically anisotropic element has been saponified.

According to an eighth aspect of the present invention, there is provided the circular polarizer of any one of the first to seventh aspects, wherein a transmissive overcoat layer is provided on a surface of the liquid crystal layer.

According to a ninth aspect of the present invention, there is provided the circular polarizer of the eighth aspect, wherein the transmissive overcoat layer is formed from an acrylic resin.

According to a tenth aspect of the present invention, there is provided the circular polarizer of any one of the first to ninth aspects, wherein the alignment direction of the liquid crystal molecules near either one of the surfaces of the liquid crystal layer is not parallel to the machine direction.

According to an eleventh aspect of the present invention, there is provided the circular polarizer of any one of the first to tenth aspects, wherein the optically anisotropic element, transmissive protection film and polarizer are each in the form of an elongate film.

According to a twelfth aspect of the present invention, there is provided a process for producing the circular polarizer of any one of the first to eleventh aspects, comprising forming a liquid crystal layer on a cellulose triacetate film, arranging a transmissive overcoat layer on the surface of the liquid crystal layer to form an optically anisotropic element, saponifying the optically anisotropic element and laminating a polarizing element via an adhesive layer to be sandwiched between the optically anisotropic element and a transmissive protection film.

According to a thirteenth aspect of the present invention, there is provided an optical film comprising the circular polarizer of any one of the first to eleventh aspects and a cholesteric liquid crystal film.

According to a fourteenth aspect of the present invention, there is provided a liquid crystal display device comprising the circular polarizer of any one of the first to eleventh aspects, arranged on at least one side of the liquid crystal cell.

According to a fifteenth aspect of the present invention, there is provided a liquid crystal display device comprising the optical film of the thirteenth aspect, arranged on at least one side of the liquid crystal cell.

According to a sixteenth aspect of the present invention, there is provided an electroluminescence device comprising the circular polarizer of any one of the first to eleventh aspects.

According to a seventeenth aspect of the present invention, there is provided the electroluminescence device of the sixteenth aspect, comprising a light diffusion layer arranged between the circular polarizer and an illuminant layer.

In the present invention, a circular polarizer is produced using an optically anisotropic element as a protection film for a polarizing element. Whereby, the number of the layers constituting the circular polarizer can be reduced than where an optically anisotropic element is attached to a polarizer wherein the both sides of a polarizing element are protected with cellulose triacetate films. As the result, the circular polarizer is less affected by shrinkage strain of each layer caused by heat or humidity and can remove defects such as peeling off at interfaces between the layers. However, it is difficult to adhere an optically anisotropic element only produced by forming a liquid crystal layer on a cellulose triacetate film, to a polarizing element. In the present invention, this is solved by saponifying the optically anisotropic element, thereby making it possible to totally achieve the objects of the present invention.

The present invention will be described in more detail below.

The liquid crystal layer forming the optically anisotropic element used in the circular polarizer of the present invention may be produced by aligning a liquid crystal polymer on an alignment substrate, and by cooling the polymer at the glass transition temperature (Tg) or lower to fix the alignment. Such a liquid crystal polymer may be a thermotropic liquid crystal polymer exhibiting liquid crystallinity when melted. The thermotropic liquid crystal polymer must maintain the molecular arrangement of the liquid crystal phase even when it is cooled from its molten state (liquid crystal state) to its glass transition temperature (Tg) or lower.

The liquid crystal phase of the liquid crystal polymer when melted may be of any molecular arrangement such as smectic, nematic, twisted nematic, cholesteric or so-called hybrid alignment wherein the molecules are aligned in a homogenous alignment and a homeotropic alignment near the aligning substrate and the interface with the air, respectively and the average directors of the liquid crystal polymer are oblique from the normal line direction of the layer.

The liquid crystal polymer may be any of various main chain liquid crystal polymers, side chain liquid crystal polymers, and mixtures thereof. Examples of the main chain liquid crystal polymers include polyester-, polyamide-, polycarbonate-, polyimide-, polyurethane-, polybenzimidazole-, polybenzoxazole-, polybenzthiazole-, polyazomethine-, polyesteramide-, polyestercarbonate- and polyesterimide-based liquid crystal polymer compounds and mixtures thereof. Among these compounds, preferred are semiaromatic polyester-based liquid crystal polymer compounds wherein mesogen groups exhibiting liquid crystallinity and flexible chains such as polymethylene, polyethyleneoxide and polysiloxane bond to one another alternately and fully aromatic polyester-based polymer compounds with no flexible chain. Examples of the side chain liquid crystal polymers include those wherein a mesogen group that is a side chain bonds to a substance having a straight-chain or cyclic main chain, such as polyacrylate-, polymethacrylate-, polyvinyl-, polysiloxane-, polyether-, polymalonate-, and polyester-based compounds and mixtures thereof. Among these compounds, preferred are side chain liquid crystal polymers wherein a mesogen group exhibiting liquid crystallinity bonds via a spacer that is a flexible chain, to the main chain and liquid crystal polymers with molecular structures having mesogen groups at the both main and side chains.

In order to induce a twisted nematic alignment, it is preferred to add a liquid crystal material containing a chiral dopant or various liquid crystal substances or non-liquid crystal substances having at least one type of chiral structural unit.

Examples of the chiral structural unit include those derived from 2-methyl-1,4-butanediol, 2,4-pentanediol, 1,2-propanediol, 2-chloro-1,4-butanediol, 2-fluoro-1,4-butanediol, 2-bromo-1,4-butanediol, 2-ethyl-1,4-butanediol, 2-propyl-1,4-butanediol, 3-methylhexanediol, 3-methyladipic acid, naproxen derivatives, camphoric acid, binaphtol, menthol, cholesteric group-containing structural units or derivatives thereof (for example, derivatives of diacetoxy compounds), all of which are optically active. The above-exemplified diols may be R-form or S-form or mixtures thereof. These structural units are mere examples and thus do not limit the present invention.

Oligomers and low molecular weight liquid crystal compounds are encompassed within the scope of the liquid crystal polymers defined in the present invention as long as they can be thermal- or photo-crosslinked to be polymerized by introducing a crosslinkable group or blending a crosslinking agent when they are in a liquid crystal state or a state wherein they are cooled to their liquid crystal transition temperature or lower to be aligned and fixed. Even discotic liquid crystal compounds may be used without any problem. Liquid crystal polymers are generally used, which exhibit optically positive or negative uniaxiality. Their optical characteristics are properly selected, depending on the functions required for the optically anisotropic element. For a twisted nematic polymer liquid crystal layer, liquid crystal polymers exhibiting positive uniaxiality are preferably used.

Examples of the low molecular weight liquid crystal compounds include those having Schiff base-, biphenyl-, terphenyl-, ester-, thioester-, stilbene-, tolan-, azoxy-, azo-, phenylcyclohexane-, pyrimidine-, cyclohexylcyclohexane-, trimesic acid-, triphenylene-, truxene-, phthalocyanine-, and porphyrin-based molecular chain structures, and mixtures thereof.

The Tg of the liquid crystal polymer affects the alignment stability thereof after being aligned and fixed and thus is preferably room temperature or higher, more preferably 50°C or higher. Tg can be controlled by selecting the type of monomer used for liquid crystal polymers, monomer ratio or polymerization conditions and also controlled by the aforesaid crosslinking.

A cellulose triacetate film is basically used as a transparent supporting film and preferably has an optical anisotropy as low as possible when the optically anisotropic element is mainly used for color compensation. When the optically anisotropic element is used for viewing angle compensation, the cellulose triacetate film may be that having optical characteristics that supplement those of the liquid crystal polymer layer. The method of forming a liquid crystal polymer layer on a cellulose triacetate film may be method A wherein a liquid crystal polymer is aligned on a cellulose triacetate film having been subjected to an alignment treatment to form a liquid crystal polymer layer directly on the film or method B wherein a liquid crystal polymer is aligned on another alignment substrate to form a liquid crystal polymer layer thereon and then transferred to a cellulose triacetate film.

In method A, it is preferred to use a cellulose triacetate film provided with an organic or inorganic alignment film. Examples of the organic alignment film include polyvinyl alcohol and polyimide derivatives. The surface on which an alignment film is provided is subjected to an alignment treatment such as rubbing.

Examples of the alignment substrate used in method B include polymer films, exemplified by thermosetting resins such as polyimides, epoxy resins and phenol resins; and thermoplastic resins such as polyamides such as nylon, polyetheretherketones (PEEK), polyketones, polyether sulfones, polyphenylene sulfides, polyphenylene oxides, polyesters such as polyethylene terephthalate and polybutylene terephthalate, polyacetals, polycarbonates, ploy(meth)acrylates, and polyvinyl alcohols. Alternatively, a polymer film may be provided on a surface with an organic film formed from the above-exemplified resins. The polymer film is subjected to an alignment treatment such as rubbing and then provided as an alignment substrate. Generally, most of the alignment substrates prepared in this manner are not suitable for use in an optically anisotropic element from the viewpoint of optical isotropy, transmissivity and physical characteristics. Therefore, the liquid crystal polymer layer formed on the alignment substrate is transferred to a cellulose triacetate film thereby producing an optically anisotropic element.

As described above, a rubbing treatment is usually carried out on an alignment substrate (including a cellulose acetate film) so as to align thereon a liquid crystal polymer. A rubbing treatment is described below with respect to a case where an optically anisotropic element is prepared in the form of an elongate film. A rubbing treatment may be carried out at any predetermined angle with respect to the machine direction of an elongate alignment substrate. The angle of the rubbing direction to the machine direction may be properly selected depending on the function of the optically anisotropic element. When a function as a color compensator is required, rubbing is preferably carried out in an oblique direction with respect to the machine direction. The angle of the oblique direction is preferably within the range of -45 degrees to +45 degrees.

A rubbing treatment may be carried out by any method. For example, an elongate film surface is passed through a rubbing roller arranged above a stage conveying the elongate film in the machine direction, at any angle with respect thereto, which rubbing roller is rotated while the elongate film is conveyed in the machine direction. The angle formed by the rubbing roller and the moving direction of the stage is adjustable with a specific mechanism, and a suitable rubbing cloth is attached to the surface of the rubbing roller.

Examples of the method of forming a liquid crystal polymer layer by bringing a liquid crystal polymer into contact with the rubbed surface of an alignment substrate include a method wherein a solution produced by dissolving a liquid crystal polymer in a suitable solvent is coated on the substrate and then dried and a method wherein a liquid crystal polymer is melt-extruded through a T-die directly on the substrate. With the objective of making the film thickness uniform, a method wherein a solution is coated and dried is suitably used. There is no particular restriction on the method of coating a solution. There may be used die-coating, slot die-coating, slide die-coating, roll coating, bar coating and dip lifting methods.

After coating, the solvent is removed by a suitable drying method and then a non-aligned liquid crystal polymer layer is formed. Thereafter, the liquid crystal polymer is aligned by heating at a predetermined temperature for a predetermined period of time and cooled to the Tg or lower thereby forming a liquid crystal polymer layer with a fixed alignment. There is no particular restriction on the thickness of the liquid crystal polymer as long as it is within such a range that the functions of an optically anisotropic element are performed. The thickness is from about 0.05 µm to 100 µm, preferably about 0.1 µm to 30 µm. Transferring of the liquid crystal polymer layer from an alignment substrate to a cellulose triacetate film may be carried out using a tacky adhesive or an adhesive.

The tacky adhesive or adhesive may be any of those such as acrylic-, epoxy-, ethylene-vinyl acetate- and rubber-based tacky adhesives or adhesives as long as they are optically isotropic. On the liquid crystal polymer layer with a fixed alignment formed on a cellulose triacetate film is arranged a transmissive overcoat layer of a photo curing type, electron radiation curing type or thermal curing type acrylic resin. When the liquid crystal polymer layer is formed by crosslinking, such a transmissive overcoat layer may not be provided. The optically anisotropic element is prepared as described above but may also be prepared by any known method as disclosed in Japanese Patent Laid-Open Publication Nos. 6-242317 and 10-339813.

The optically anisotropic element is laminated to a polarizer but is saponified before lamination. Saponification is usually carried out by bringing the optically anisotropic element into contact with an alkali aqueous solution. The alkali aqueous solution may be an aqueous solution of potassium hydroxide or sodium hydroxide. The alkali aqueous solution, the alkali concentration of which is diluted to from about 0.1 to 10 percent by mass, preferably from about 0.5 to 5 percent by mass, more preferably from about 1 to 3 percent by mass may be sufficiently used. Saponification may be carried out under moderate conditions such as room temperature for 1 to 60 minutes, preferably 30 minutes or shorter, more preferably 15 minutes or shorter. The liquid crystal polymer layer with an overcoat layer is not corroded or damaged during saponification.

The polarizing element used in the present invention may be generally any of those produced by allowing iodine or dichroic dyes to be adsorbed in a base material such as a stretched polyvinyl alcohol (PVA) film. A polarizing element is usually sandwiched by protection films to be formed into a polarizer, and the protection film is usually a cellulose triacetate film. In the present invention, a circular polarizer may be produced by laminating the above-described optically anisotropic element as a protection film on at least one surface of the polarizing element.

The polarizing element and optically anisotropic element may be laminated to one another via an acrylic-, SBR- or silicone-based tacky adhesive or adhesive. The polarizing element may be laminated on the liquid crystal polymer surface coated with a transmissive overcoat layer or the cellulose triacetate film surface of the optically anisotropic element. However, the polarizing element is preferably laminated on the cellulose triacetate surface.

The transmissive protection film used in the present invention may be the above-described optically anisotropic element but is preferably a commercially available transmissive film with a small optical anisotropy under the trade names of ZEONOR and ZEONEX both manufactured by ZEON CORPORATION, ARTON manufactured by JSR, or Fujitac manufactured by Fuji Photo Film Co. , Ltd. The thickness of the transmissive protection film is generally 200 µm or less, preferably from 1 to 100 µm, particularly preferably from 5 to 50 µm. The transmissive protection film and the polarizing element are laminated by the same method as that of laminating the optically anisotropic element.

The circular polarizer of the present invention comprises at least a polarizing element layer and an optically anisotropic element having a retardation of approximately 1/4 wavelength in the visible light region. The optically anisotropic element may be composed of a plurality of liquid crystal polymer layers, but sufficient optical characteristics can be obtained with an optically anisotropic element even with a single layer of liquid crystal polymer.

The optically anisotropic element constituting the circular polarizer of the present invention contains a liquid crystal film with a fixed twisted nematic alignment and has a retardation of approximately 1/4 wavelength in the visible light region.

The liquid crystal film constituting the optically anisotropic element denotes a film having an optically anisotropic axis and a fixed twisted nematic alignment structure wherein the optically anisotropic axis is twisted from one surface to the other surface. Therefore, this liquid crystal film has characteristics equivalent to those of a laminate wherein layers each having an optical anisotropy are superposed so that their optically anisotropic axes are continuously twisted and has a retardation (=Δnd: the value represented by the product of birefringence Δn and thickness d (nm) and twisted angle, similarly to a normal TN (twisted nematic) liquid crystal cell or STN (super twisted nematic) liquid crystal cell. The fixed alignment denotes that the alignment is maintained without being disordered under the conditions where the liquid crystal film is used. A similar alignment state can be produced in a liquid crystal cell. However, the fixing of the alignment can remove glass sheets as used for a liquid crystal cell thereby achieving decreases in weight and thickness and an improvement in handling characteristics. Alternatively, the liquid crystal film may be of a temperature compensation type wherein the retardation changes as the temperature conditions change and returns as the temperature returns.

It is desirous to use a liquid crystal film, wherein the product of the birefringence Δn with respect to 550 nm wavelength light and the thickness d (nm) of the liquid crystal film is not less than 140 nm and not greater than 300 nm, and the twisted angle is not smaller than 30 degrees and not greater than 85 degrees in view of circular polarizing characteristics. Furthermore, it is particularly preferred to use a liquid crystal film, wherein the combination of the product of the birefringence Δn with respect to 550 nm wavelength light and the thickness d (nm) and the twisted angle satisfies any of the conditions of (1) not less than 155 nm and not greater than 175 nm, and not smaller than 40 degrees and not greater than 50 degrees; (2) not less than 176 nm and not greater than 216 nm, and not smaller than 58 degrees and not greater than 70 degrees; and (3) not less than 230nm and not greater than 270 nm, and not smaller than 70 degrees and not greater than 80 degrees because it exhibits excellent circular polarizing characteristics when combined with the above-described polarizing element. There are two types of the twisted direction but it may be right-hand twist or left-hand twist.

The circular polarizer of the present invention comprises at least the above-described polarizing element, optically anisotropic element comprising a liquid crystal layer aligned on a cellulose triacetate film, and transmissive protection film. There is no particular restriction on the thickness of the circular polarizer of the present invention. However, it is possible to make the thickness usually 300 µm or less, preferably 250 µm or less, more preferably 220 µm or less, more preferably 200 µm or less.

In addition to the polarizing element, optically anisotropic element, transmissive protection film, the circular polarizer of the present invention may contain any one or more selected from an anti-reflection layer, an anti-glare layer, a hard coat layer, an adhesive layer, a tacky adhesive layer, a light diffusion layer, and a light diffusive adhesive layer.

A liquid crystal display device to which the circular polarizer of the present invention is applied will now be described below.

The liquid crystal display device of the present invention has at least the above-described circular polarizer. A liquid crystal display device is usually composed of a polarizer, a liquid crystal cell, and if necessary, parts such as a retardation compensator, a reflection layer, a light diffusion layer, a back light, a front light, a light controlling film, a light guiding plate and a prism sheet. However, there is no particular restriction on the present invention except that the above-described circular polarizer is used. There is no particular restriction on the position of the circular polarizer, which may be arranged in a single position or a plurality of positions.

There is no particular restriction on the polarizer used in the liquid crystal display device. The polarizer may be a polarizer formed of the same polarizing element as used for the above-described circular polarizer.

There is no particular restriction on the liquid crystal cell, which may therefore, be a conventional liquid crystal cell wherein a liquid crystal layer is sandwiched between a pair of transparent substrates each provided with an electrode.

There is no particular restriction on the transparent substrate constituting the liquid crystal cell as long as it aligns a material exhibiting liquid crystallinity, forming the liquid crystal layer, in a specific alignment direction. More specific examples include those which themselves have a property of aligning a liquid crystalline material and those which themselves have no capability of aligning but are provided with an alignment layer capable of aligning a liquid crystalline material. The electrode of the liquid crystal cell may be a conventional one. The electrode may be usually arranged on the surface of the transparent substrate, which surface contacts the liquid crystal layer. In the case of using a transparent substrate with an alignment layer, an electrode is provided between the alignment layer and the transparent substrate.

There is no particular restriction on the material exhibiting liquid crystallinity, forming the liquid crystal layer. Examples of such materials include various low molecular weight liquid crystal substances, polymeric liquid crystal substances, and mixtures thereof, which can form various liquid crystal cells. The liquid crystalline material may be blended with dyes, chiral dopoants, or non-liquid crystalline substances to an extent that they do not prevent the liquid crystal substance from exhibiting liquid crystallinity.

In addition to the above-described electrode, substrate, and liquid crystal layer, the liquid crystal cell may be provide with various constituting elements necessary to be used in the following mode.

Examples of the liquid crystal mode include TN (Twisted Nematic), STN (Super Twisted Nematic), ECB (Electrically Controlled Birefringence), IPS (In-Plane Switching), VA (Vertical Alignment), OCB (Optically Compensated Birefringence), HAN (Hybrid-Aligned Nematic), ASM (Axially Symmetric Aligned Microcell), Half Tone Gray Scale modes, domain segmented mode, display modes using a ferroelectric liquid crystal and an antiferroelectric liquid crystal.

There is no particular restriction on the driving mode of the liquid crystal cell, either, which may, therefore, be a passive matrix mode used in an STN-LCD, an active matrix mode using active electrodes such as TFT (Thin Film Transistor) electrodes and TFD (Thin Film Diode) electrodes, and a plasma address mode.

There is no particular restriction on the retardation compensator used in the liquid crystal display device as long as it is excellent in transparency and uniformity. However, the retardation compensator is preferably a stretched polymer film or an optical compensation film formed from a liquid crystal material. Examples of the stretched polymer film include uniaxial or biaxial retardation films formed from cellulose-, polycarbonate-, polyarylate-, polysulfone-, polyacryl-, polyethersulfone-, and cyclic olefin-based polymer compounds. Among these, polycarbonate-based polymer compounds are preferable in view of cost and film uniformity. There is no particular restriction on the optical compensation film formed from a liquid crystal material as long as it can utilize optical anisotropy derived from the liquid crystal material when aligned. For example, there may be used conventional films such as various optically functioning films utilizing nematic, discotic and smectic liquid crystals.

The exemplified retardation compensator may be used alone or in plural in the liquid crystal display device. A stretched polymer film and an optical compensation film formed from a liquid crystal material may be used in combination.

There is no particular restriction on the reflection layer, which may, therefore, be a metal such as aluminum, silver, gold, chromium, and platinum, an alloy containing one or more of these metals, an oxide such as magnesium oxide, a multi-layered film of dielectrics, a liquid crystal film exhibiting a selective reflectivity, and combinations thereof. These reflector may be flat or curved and may be those provided with diffusive reflectivity by forming rugged patterns on its surface; those having a function as the electrode on the transparent substrate located on the side opposite to the viewer's side; transflectors which are made thin or provided with holes so as to transmit a part of light; or any combination thereof.

There is no particular restriction on the light diffusion layer as long as it has properties to diffuse incident light isotropically or anisotropically. For example, there may be used those comprising two or more regions and having a refractive index difference therebetween or those having on their surfaces rugged patterns. Examples of the light diffusion layer comprising two or more regions and having a refractive index difference therebetween include those wherein particles having a different refractive index from those of matrixes are dispersed therein. The light diffusion layer itself may have tacky adhesivity or adhesivity.

Although not restricted, the thickness of the light diffusion layer is usually 10 µm or more and preferably 500 µm or less.

The total light transmittance of the light diffusion layer is preferably 50 percent or more and particularly preferably 70 percent or more. The haze value of the layer is generally from 10 to 95 percent, preferably from 40 to 90 percent, and more preferably from 60 to 90 percent.

There is no particular restriction on a back light, a front light, a light-controlling film, a light guide plate, and a prism sheet used for the liquid crystal display device. Therefore, they may be conventional ones.

In addition to the above-described components, the liquid crystal display device of the present invention may be provided with another additional components. For example, the use of a color filter makes it possible to produce a color liquid crystal display device which can provide multi- or full-colored display images with increased color purity.

The liquid crystal display device is a transflective liquid crystal display device comprising at least a liquid crystal cell constituted by sandwiching a liquid crystal layer between a pair of transparent substrates each provided with an electrode, a polarizer disposed on the viewer's side of the liquid crystal cell, at least one retardation compensation film disposed between this polarizer and the liquid crystal cell, and a transflector disposed in the rear of the liquid crystal layer, viewed from the viewer, wherein the above-described circular polarizer is preferably disposed in the rear of the transflector, viewed from the viewer. This type of liquid crystal display device is operable both in a reflective mode and in a transmissive mode by arranging a back light in the rear of the circular polarizer.

For example, in the case of using an STN-LDC mode liquid crystal cell, the retardation compensation film preferably comprises two sheets of the above-described stretched polymer films and/or one sheet of the above-described optical compensation film formed from a liquid crystal material because excellent display images can be produced.

The optical compensation film formed from a liquid crystal material is particularly preferably an optical compensation film with a fixed twisted nematic alignment. The combination of the retardation and twisted angle of the optical compensation film can not be determined with certainty because it depends on the retardation and twisted angle of the liquid crystal cell to be used. However, the combination is usually not less than 400 nm and not more than 1200 nm and not smaller than 150 degrees and not greater than 220 degrees, preferably not less than 500 nm and not more than 1000 nm and not smaller than 160 degrees and not greater than 210 degrees, more preferably not less than 600 nm and not more than 850 nm and not smaller than 170 degrees and not greater than 200 degrees. The twisted direction of the optical compensation film is preferably opposite to the twisted direction of the liquid crystal cell. Preferably, the liquid crystal display device comprises a diffusion layer between the polarizer and the liquid crystal cell or a diffusion reflective transflective layer as an electrode of the liquid crystal cell because excellent display characteristics can be obtained.

Examples of other liquid crystal display devices include reflective or transflective liquid crystal display devices using a liquid crystal cell of an ECB or TN-LCD mode. The twisted angle of the TN-LCD mode liquid crystal cell is usually not smaller than 0 degree and not greater than 85 degrees, preferably not smaller than 0 degree and not greater than 80 degrees, more preferably not smaller than 0 degree and not greater than 70 degrees because excellent display characteristics can be obtained when the cell is used in combination with the circular polarizer of the present invention.

Next, description will be given to an optical film comprising the circular polarizer of the present invention and a cholesteric liquid crystal film.

The optical film comprises a polarizing element, a 1/4 wavelength plate, and a cholesteric liquid crystal film laminated in this order thereby forming a linear polarizer with a brightness enhancement function.

The cholesteric liquid crystal film may be any of various films used as a brightness enhancement film without any restriction. Examples of the cholesteric liquid crystal film include those exhibiting characteristics that they reflect either one of right-handed or left-handed circularly polarized light and transmit the other, such as aligned films of cholesteric liquid crystalline polymers and such films supported on a film substrate. The cholesteric liquid crystal film may be any of those exhibiting circular dichroism in a part of spectrum of visible light or exhibiting circular dichroism in a spectrum of 200 nm or more in a visible light. The cholesteric liquid crystal film may be formed from a cholesteric liquid crystal polymer containing an optically active group-containing monomer as a monomer unit. Since the pitch of the cholesteric liquid crystal varies on the basis of the content of the optically active group-containing monomer, the circular dichroism can be controlled with the content of the monomer unit. The thickness of the cholesteric liquid crystal film is preferably usually from 0.5 to 30 µm, particularly preferably from 2 to 15 µm. The cholesteric liquid crystal film may be blended with one or more additives selected from polymers other than the above-described polymers, stabilizers, inorganic compounds such as plasticizers, organic compounds, metals, compounds thereof if necessary.

The cholesteric liquid crystal film may be of an overlaid structure of two or more layers with different reflection wavelength in combination so that it can reflect a circularly polarized light in a wide wavelength range such as a visible light region thereby producing a transmissive circularly polarized light in a wide wavelength range.

In the optical film produced by laminating the circular polarizer of the present invention and a cholesteric liquid crystal film, a laminate of the 1/4 wavelength plate and the cholesteric liquid crystal film has a brightness enhancement function and the polarizing element has a function as a linear polarizer. The laminate of the 1/4 wavelength plate and the cholesteric liquid crystal film is herein defined as a brightness enhancement film.

A polarizer wherein the polarizing element and the brightness enhancement film are laminated is arranged on the rear side of the liquid crystal cell for actual use. The brightness enhancement film exhibits characteristics that it reflects a linearly polarized light with a certain polarization axis or a circularly polarized light in a certain direction, upon incidence of light from the backlight of the liquid crystal display device or natural light reflected at the rear side of the liquid crystal cell and transmits the other light. The polarizer wherein the polarizing element and the brightness enhancement film are laminated produces a transmitted light in a certain polarization state by making an incident of light from the light source such as a back light and does not transmit but reflects the light other than the light in the certain polarization state. The light reflected on the brightness enhancement film surface is reversed by a reflection layer arranged on the rear side of the enhancement film so as to be made incident thereto again, and the whole or a part of the incident light is allowed to transmit in the form of the light in the certain polarized state thereby increasing the amount of the light transmitting through the brightness enhancement film and enhancing the brightness by increasing the amount of the light by supplying the polarized light which is hard to be absorbed by the polarizing element, to be used for liquid crystal image display.

That is, when a light is made incident from the rear side of the liquid crystal cell by the back light, through the polarizer, without using the brightness enhancement film, most of the light having the polarization direction which does not correspond to the polarization axis of the polarizer is absorbed thereby and does not transmit through the polarizer. That is, about 50 percent of the light is absorbed by the polarizer though depending on the characteristics of the polarizer, and thus the amount of the light which can be used for liquid crystal image displaying is decreased by the amount, resulting in dark images. The brightness enhancement film repeatedly reflects the light in the polarization direction which can be absorbed by the polarizer, not allowing the light to be made incident thereto and further reverses the light by a reflection layer arranged on its rear side so as to be made incident to the brightness enhancement film again. The brightness enhancement film transmits and supplies only the polarized light reflected and reversed between the film and the reflection layer, the polarization direction of which polarized light is changed so as to be allowed to transmit through the polarizer. As the result, the brightness enhancement film can use the light from the backlight efficiently for the image display of a liquid crystal display device and thus can brighten the viewing surface thereof.

Next, an organic electroluminescence device (organic EL display device) to which the circular polarizer of the present invention is applied will be described. In general, an EL display device comprises an illuminant (organic electroluminescent illuminant) formed by laminating a transparent electrode, an organic illuminant layer, and a metal electrode in this order on a transparent substrate. The organic illuminant layer is a laminate of various organic films and for example is known to be of various structures such as a laminate of a hole injection layer of a triphenylamine derivative and an illuminant layer of a fluorescent organic solid such as anthracene; a laminate of such an illuminant layer and an electron injection layer of a perylene derivative, and a laminate of such a hole injection layer, an illuminant layer, and an electron injection layer.

The organic EL display device illuminates on the basis of the principle that when an electric voltage is applied to the transparent electrode and the metal electrode, causing holes and electrons to be injected to the organic illuminant layer, the energy generated by the re-coupling of the holes and electrons excites the fluorescent substance and light is emitted when the excited fluorescent substance returns to a ground state. The re-coupling is the same in mechanism as an ordinary diode. As anticipated from this, the current and luminescence intensity exhibit strong non-linearity accompanying rectification characteristics to the applied electric voltage.

In the organic EL display device, at least one of the electrodes must be transparent in order to take out the light emitted in the organic illuminant layer, and thus a transparent electrode formed from a transparent conductive material such as Indium Tin Oxide (ITO) is usually used as an anode. While, since it is important to use a substance which is small in work function for a cathode in order to make the injection of electrons easy and thus increase the illumination efficiency, a metal electrode such as Mg-Ag and Al-Li is used.

In the organic EL display device with the above-described structure, the organic illuminant layer is formed of an extremely thin film with a thickness of on the order of 10 nm. The organic illuminant layer thus also transmits light substantially completely, similarly to the transparent electrode. Consequently, since during the non-illumination mode, the light made incident through the transparent substrate transmits through the transparent electrode and organic illuminant layer, and then reflects at the metal electrode and then appears on the surface of the transparent substrate again, the displaying surface of the organic EL display device look like a mirror when viewed from the outside.

In the organic EL display device wherein the organic illuminant layer illuminating upon application of an electric voltage is provided with on its top surface with a transparent electrode and on its bottom surface with a metal electrode, a polarizer may be provided on the top surface side of the transparent electrode, and a retardation film may be provided between the transparent electrode and the polarizer.

The retardation film and polarizer have a function to polarize a light externally made incident and reflected at the metal electrode and thus an effect not to make the mirror surface of the metal electrode visible with the action. In particular, when the retardation film is formed of a 1/4 wavelength plate and the angle formed by the polarization directions of the polarizer and the retardation film is adjusted to π/4, the mirror surface of the metal electrode can be completely shielded.

That is, for an external light made incident to the organic EL display device, only the linearly polarized component transmits therethrough due to the presence of the polarizer. This linearly polarized light becomes an elliptically polarized light due to the presence of the retardation film but becomes a circularly polarized light in particular when the retardation film is a 1/4 wavelength plate and the angle formed by the polarization directions of the polarizer and retardation film is adjusted to n/4.

The circularly polarized light becomes a linearly polarized light again at the retardation film after transmitting through the transparent substrate, transparent electrode, and organic thin film, reflected at the metal electrode and transmitting through the organic thin film, transparent electrode, and transparent substrate. The linearly polarized light crosses with the polarization direction of the polarizer and thus can not transmit therethrough. As the result, the mirror surface of the metal electrode can be completely shielded.

### [Applicability in the Industry]

The circular polarizer of the present invention is hardly damaged on the liquid crystal polymer layer during the lamination of the optically anisotropic element and the polarizing element, excellent in adhesivity of the optically anisotropic element, and is useful as a film for image display devices such as various liquid crystal display devices and organic EL display devices. Further, since the circular polarizer is fewer in the number of the laminated layers, it is free from peeling off at interfaces between the layers or foaming in an accelerated durability test. In the step of laminating the optically anisotropic element and the polarizing element, they can be laminated in the form of an elongate film, resulting in an advantage that the laminating step can be rationalized, compared with the conventional method.

### [Best Mode for Carrying out the Present Invention]

The present invention will be further described in the following examples, but the present invention should not be construed as being limited thereto.

The retardations (And)in the examples are values at a wavelength of 550 nm, unless stated otherwise.

Inherent viscosity used in the examples was measured in a mixed solvent of phenol/tetrachloroethane (60/40 mass ratio) at a temperature of 30°C using an Ubbellohde viscometer.

### [Reference Example 1]

Among optical retardation films (twisted optical retardation films) with twisted structures each having a twisted angle and a retardation as parameters, films having such parameters that they can function as a circular polarizer in combination with a polarizer were sought. Since in a laminate composed of a polarizer, a twisted optical retardation film, and a mirror, the rotation direction of a circularly polarized light is reversed when it is reflected at the mirror surface, the reflectance of a light made incident vertically to the mirror from the polarizer side is ideally zero. Using this principle, in a laminate comprised of a polarizer, a twisted optical retardation film, and a mirror, the combinations of parameters such as the absorption axis direction of the polarizer and the twisted angle and retardation of the optical retardation film are calculated with an extended Jones matrix method. From the results of the calculation, the reflectance was evaluated with "Y" value which indicates luminance having been subjected to visual compensation so as to extract the combinations whose Y values are lowered, i.e., darkened to the equal extent to which are obtained using a conventional non-twisted uniaxial λ/4 wavelength plate. As a result, it was found that excellent circular polarization properties can be obtained in the case where the retardation to a light at a wavelength of 550 nm, of the twisted optical retardation film is within the range of 140 nm or greater and 400 nm or lower and the twisted angle is within the range of 30 degrees or larger and 85 degrees or smaller. Furthermore, it was also found that particularly excellent circular polarization properties were able to be obtained with around 3 parameter groups in combination set forth in Table 1 below.

**Table 1**

| No. | Absorption axis direction of polarizer | Twisted angle | Retardation |
|---|---|---|---|
| #1 | -15° or +75° | +45° | 165nm |
| | +15° or -75° | -45° | |
| #2 | 0 or 90° | ±64° | 196nm |
| #3 | +15° or -75° | +75° | 250nm |
| | -15° or +75° | -75° | |

In this reference example, the optical axis of the twisted optical retardation film at the side contacting with the polarizer is defined as "0 degree", the angle of anti-clockwise direction from the polarizer toward the mirror surface is defined as "+", and the angle of clockwise direction is defined as "-".

The value "Y" corresponds to the polarizability of circular polarization obtained with the circular polarizer of the present invention. Therefore, the upper limit of the value "Y" depends on the usage or purpose of the circular polarizer of the present invention and thus can not be determined with certainty. However, the parameter groups are preferably within the range set forth in Table 2 below and more preferably within the range set forth in Table 3 below. The parameter groups in excess of these ranges would fail to obtain sufficient circular polarization properties.

**Table 2**

| No. | Absorption axis direction of polarizer | Twisted angle | Retardation |
|---|---|---|---|
| #1 | -15° or+75° ±15° | +45° ±5° | 165nm±10nm |
| | +15° or-75° ± 15° | -45° ±5° | |
| #2 | 0 ° or 90° ±15° | ±64° ±6° | 196nm±20nm |
| #3 | +15° or -75° ±15° | +75° ±5° | 250nm±20nm |
| | -15° or +75° ±15° | -75° ±5° | |

**Table 3**

| No. | Absorption axis direction of polarizer | Twisted angle | Retardation |
|---|---|---|---|
| #1 | -15° or +75° ±10° | +45° ±4° | 165nm±5nm |
| | +15° or -75° ±10° | -45° ±4° | |
| #2 | 0 ° or 90° ± 10° | ±64° ±4° | 196nm±10nm |
| #3 | +15° or -75° ± 10° | +75° ±4° | 250nm±10nm |
| | -15° or +75° ± 10° | -75° ±4° | |

### [Example 1]

### (Preparation of polymer solution A)

A polymerization was carried out using 50 mmole of terephthalic acid, 50 mmole of 2,6-naphthalene dicarboxylic acid, 40 mmole of methylhydroquinone diacetate, 60 mmole of catechol diacetate, and 60 mg of N-methylimidazole under a nitrogen atmosphere at a temperature of 270°C for 12 hours. The resulting reaction product was dissolved in tetrachloroethane and then purified by reprecipitating with methanol thereby obtaining 14.7 g of a liquid crystalline polyester. It was found that this liquid crystalline polyester (polymer 1) had an inherent viscosity of 0.17 (dl/g), a nematic liquid crystalline phase, an isotropic phase-liquid crystalline phase transition temperature of 250°C or higher, and a glass transition temperature of 115°C.

In dichloromethane, 90 mmol of biphenyldicarbonylchloride, 10 mmol of terephthaloylchloride, 105 mmol of S-2-methyl-1,4-butanediol were reacted at room temperature for 20 hours, and the reaction solution was put into methanol to be repricipitated thereby obtaining 12.0 g of a liquid crystalline polyester (polymer 2). The inherent viscosity of polymer 2 was 0.12.

A mixed polymer of 19.82 g of polymer 1 and 0.18 g of polymer 2 was dissolved in N-methylpyrrolidone to be contained in an amount of 20 percent by mass thereby preparing a polymer solution A.

### (Production of Optically anisotropic Element B)

While an elongate PEEK film with a width of 650 mm and a thickness of 100 µm was conveyed, the film was continuously rubbed with a 150 mm ø rubbing roller around which a rayon cloth was wrapped, arranged obliquely to the film and rotated at a high speed thereby producing an alignment substrate film with a rubbing angle of 25 degrees. Herein, the rubbing angle is defined as the angle in the counterclockwise direction when the rubbed surface was viewed from the above. The polymer solution A was continuously coated on the alignment substrate film using a die coater and dried thereby forming a liquid crystal polymer layer not aligned, which was then heated at a temperature of 200°C for 10 minutes so as to be aligned and was cooled to room temperature to fix the alignment. The resulting liquid crystal polymer layer was aligned in a twisted nematic alignment wherein the twisted angle was -64 degrees and the Δnd was 196 nm. The liquid crystal polymer layer was transferred to an unsaponified cellulose triacetate film with a thickness of 40 µm using an ultraviolet curing type acrylic adhesive (PEEK film was peeled off). In order to protect the exposed surface, the same acrylic adhesive was coated thereon and cured thereby forming a transmissive overcoat layer. As the result, an optically anisotropic element B with a total thickness of about 60 µm was produced.

### (Production of Circular Polarizer C)

The optically anisotropic element B had been dipped in a 2 percent by mass potassium hydroxide aqueous solution at room temperature for 5 minutes to be saponified and washed in flowing water and dried. On one surface of a polarizing element that was a stretched polyvinyl alcohol adsorbing iodine was continuously laminated via an acrylic adhesive the saponified optical anisotropic element B so that the liquid crystal polymer layer is to be the outermost surface of the laminate. On the other surface of the polarizing element was laminated a cellulose triacetate film having been saponified thereby producing a circular polarizer C of the present invention. The total thickness of the circular polarizer was about 130 µm which was thinner than the conventional ones. The circular polarizer C was subjected to ellipsometry using an ellipsometer (DVA-36VWLD manufactured by Mizojiri Optical Co., Ltd.) and was found to be 0.94 in ellipticity at a wavelength of 550 nm, thereby confirming that it was a circular polarizer with excellent circular polarization properties. Further, the circular polarizer C was optically inspected and found to have no damage such as stain or scar on the liquid crystal polymer layer. On the optically anisotropic element B of the circular polarizer C was laminated via an acrylic tacky adhesive a glass sheet. The laminate was then placed in a constant temperature and humidity bath kept at 60°C and 90%. After the lapse of 500 hours, the laminate was taken out from the bath and observed. As the result, no defect such as peeling off or foaming was observed at all.

### [Example 2]

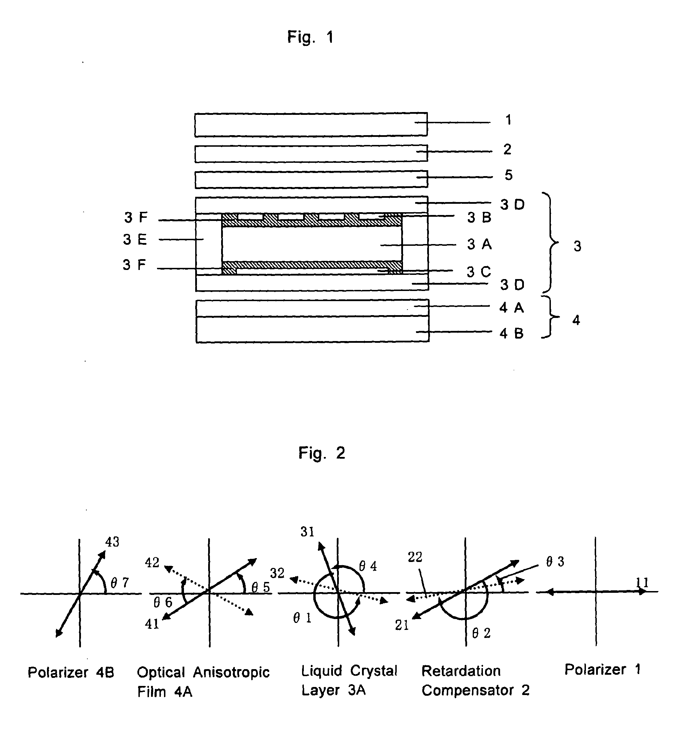

A transflective STN liquid crystal display with a structure as shown in Fig. 1 was produced using the circular polarizer produced in Example 1. In this example, the experiments were conducted using a liquid crystal cell wherein the counterclockwise direction from the polarizer 1 to the liquid crystal cell 3 was defined as "+", while the clockwise direction was defined as "-". However, the same results were obtained using a liquid crystal cell wherein the counterclockwise direction was defined as "-", while the clockwise direction was defined as "+".

As shown in Fig. 1, a liquid crystal cell 3 is provided with a pair of substrates 3D facing each other, an upper electrode 3B formed on the lower surface of the upper substrate, a transflective electrode 3C formed on the upper surface of the lower substrate, and alignment layers 3F printed on each electrode and having been subjected to an alignment treatment. A liquid crystal layer 3A was formed by injecting a liquid crystalline substance into a space defined by the alignment layers 3F and an sealant layer 3E formed around the peripheral edges of the substrates by printing.

Fig. 2 shows the relationships among the angles θ1 to θ7 of components in the above STN type transflective liquid crystal display device.

In Fig. 2, the alignment direction 31 on the surface facing the polarizer 1 and alignment direction 32 on the surface facing the circular polarizer 4, of the liquid crystal layer 3A form an angle θ1. The alignment axis direction 21 on the surface facing the polarizer 1 and alignment axis direction 22 on the surface facing the liquid crystal cell, of the retardation compensator 2 form an angle θ2. The alignment axis direction 41 on the surface facing the polarizer 1 and alignment axis direction 42 on the surface facing the polarizer 4B, of the optically anisotropic element 4A form an angle θ6. The absorption axis 11 of the polarizer 1 and the alignment axis direction 21 on the surface facing the polarizer 1, of the optical retardation compensator 2 forms an angle θ3, while the absorption axis 11 of the polarizer 1 and the alignment direction 31 on the surface facing the polarizer 1, of the liquid crystal layer 3A form an angle θ4. The alignment direction 41 on the surface facing the liquid crystal cell, of the optically anisotropic element 4A forming the circular polarizer and the absorption angle 11 of the polarizer 1 form an angle θ5, while the absorption axis 43 of the polarizer 4B and the absorption angle 11 of the polarizer 1 form an angle θ7.

ZLI-2293 manufactured by Merck Ltd. was used as the liquid crystalline material, and the liquid crystal layer 3A was aligned in a predetermined direction by adjusting the alignment treatment direction of the alignment layers 3F so as to be twisted at an angle θ1 = +250 degrees. The product Δnd of the refractive index anisotropy Δn of the liquid crystalline substance in the liquid crystal cell 3A and the thickness d thereof was about 800 nm.

A polarizer 1 (thickness: 180 µm; SQW-862 manufactured by Sumitomo Chemical Industry Co., Ltd.) was disposed on the displaying surface (the upper portion in the drawing) of the liquid crystal cell 3. Between the polarizer 1 and the liquid crystal cell 3 was inserted an optical retardation compensator 2 formed from a liquid crystal film wherein a twisted nematic alignment structure was fixed. This optical retardation compensator 2 was produced in accordance with the procedures in Example 1 for producing the optically anisotropic element B. The optical retardation compensator 2 had a Δnd of about 670 nm and a twisted angle θ2 of -190 degrees. The angle θ3 formed by the absorption axis of the polarizer 1 and the aligned axis on the surface facing the polarizer of the optical retardation compensator 2 was set at +20 degrees, while the angle θ4 formed by the absorption axis of the polarizer 1 and the aligned direction on the surface facing the polarizer of the liquid crystal layer 3A was set at +105 degrees.

Furthermore, the circular polarizer C produced in Example 1 was placed as the circular polarizer 4 defined in Fig. 1, in the rear of the liquid crystal cell viewing from the viewer. The circular polarizer 4 was composed of a polarizer 4B and an optically anisotropic element 4A formed from a liquid crystal film with a fixed twisted nematic alignment structure (And=196 nm, twisted angle A6=-64 degrees) . The angle 65 formed by the absorption axis of the polarizer 1 and the aligned axis on the surface facing the liquid crystal cell, of the polarizer of the optically anisotropic element 4A was set at +35 degrees, while the angle θ7 formed by the absorption axis of the polarizer 1 and the absorption axis of the polarizer 4B was set at +60 degrees.

Furthermore, between the optical retardation compensator 2 and the liquid crystal cell 3 was arranged a tacky adhesive layer 5 (total light transmittance and haze value were 90 percent and 80 percent, respectively) having light diffusion properties, while between the polarizer 1 and the optical retardation compensator 2 and between the liquid crystal cell 3 and the circular polarizer 4 are arranged conventional transparent tacky adhesive layers.

A driving voltage (1/240 duty, driven at the optimized bias) was applied from a driving circuit (not shown) to the electrodes 3B, 3C of the liquid crystal display, and a back light was placed so as to examine the optical characteristics at the time the light is off (reflection mode) and on (transmission mode), respectively. It was confirmed that the display device was able to display a bright image of high contrast both in the reflection and transmission modes and had excellent viewing angle properties particularly in the transmission mode.

In this example, the experiment was conducted without using a color filter. However, needless to mention, the provision of a color filter in the liquid crystal cell results in excellent multi- or full color displaying. In this example, excellent displaying can be achieved using two sheets of polycarbonate biaxial optical retardation films as the optical retardation compensation film.

### [Example 3]

On a cellulose triacetate film (80 µm) was formed a cholesteric liquid crystal layer (5 µm) exhibiting circularly dichroism in a spectrum of 400 to 700 nm, and on the liquid crystal layer was laminated via a tacky adhesive layer (25 µm) formed of an acrylic tacky adhesive the circular polarizer C produced in Example 1 so that the optically anisotropic element B faces the cholesteric liquid crystal layer, thereby producing a linear polarizer D with a brightness enhancement film.

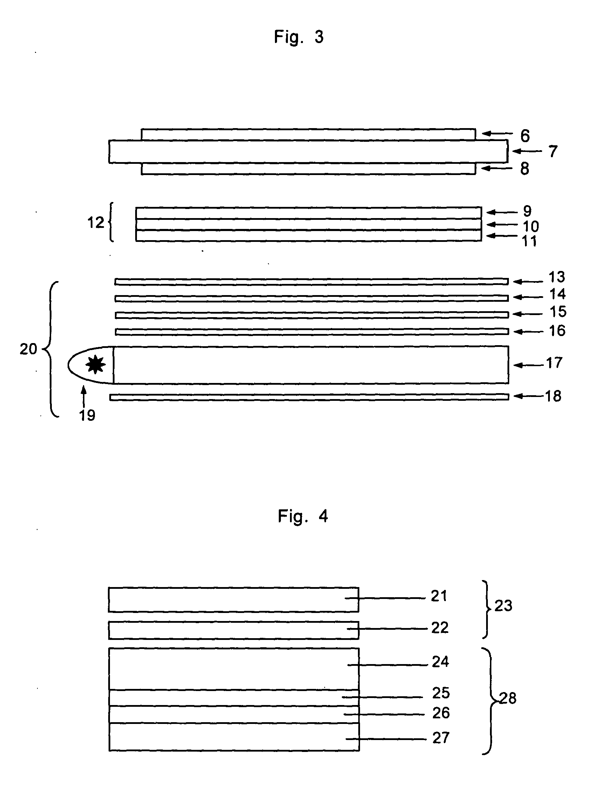

The resulting linear polarizer D with a brightness enhancement film was arranged in a commercially available liquid crystal display comprising a back light, a lower polarizer, a liquid crystal cell, and an upper polarizer arranged in this order, in place of the lower polarizer so that a back light, a brightness enhancement film (cholesteric liquid crystal film, optically anisotropic element B), a lower polarizer, a liquid crystal cell, and an upper polarizer are arranged in this order as shown in Fig. 3. As the result, it was confirmed that the image was enhanced in brightness by 30 percent, compared with a display device with no brightness enhancement film.

### [Example 4]

The circular polarizer C produced in Example 1 was attached as the circular polarizer 23 as defined in Fig. 4 to the transparent glass substrate 24 of the organic EL element 28 of a commercially available organic EL display, via an acrylic tacky adhesive, thereby producing an organic EL element of the present invention. As the result, it was confirmed that the organic EL element exhibited a significant eternal light anti-reflection effect and was excellent in visibility, compared with an arrangement with no circular polarizer.

### [Comparative Example 1]

An alkyl-modified polyvinyl alcohol was coated and dried on a cellulose triacetate film with a thickness of 40 µm, having been saponified and then subjected to the rubbing treatment with the method used when the optically anisotropic element B was produced, thereby producing an alignment film with a rubbing angle of 25 degrees. The above-produced polymer solution A was coated on the cellulose triacetate film in an elongate form, having been subjected to the rubbing treatment and dried and heated to align and fix the liquid crystal polymer layer. The resulting liquid crystal layer was aligned in a twisted nematic alignment wherein the twisted angle was -64 degrees and the Δnd was 196 nm. In order to protect the surface of the liquid crystal polymer layer, an ultraviolet curing type acrylic adhesive was coated thereon thereby producing an optically anisotropic element E with a total thickness of about 60 µm.

In accordance with the procedures of Example 1, on one surface of a polarizing element was laminated the optically anisotropic element E so that the liquid crystal polymer layer is to be the outermost surface of the laminate, and on the other surface was laminated a saponified cellulose triacetate film thereby producing a circular polarizer F. The resulting circular polarizer F was subjected to ellipsometry using an ellipsometer (DVA-36VWLD manufactured by Mizojiri Optical Co., Ltd.) and was found to be 0.94 in ellipticity at a wavelength of 550 nm, thereby confirming that it was a circular polarizer with excellent circular polarization properties. On the optically anisotropic element E of the circular polarizing film F was laminated via an acrylic tacky adhesive a glass sheet. The same test as that in Example 1 was carried out. After the lapse of 100 hours, it was confirmed that peeling off between the polarizing element and the cellulose triacetate film of the optically anisotropic element E occurred.

### [Comparative Example 2]

The procedures for producing the optically anisotropic element B were followed except that an acrylic adhesive for surface protection was not coated thereby producing an optically anisotropic element G. The liquid crystal polymer layer of the optically anisotropic element G was aligned in a twisted nematic alignment wherein the twisted angle was -64 degrees and the Δnd was 196 nm.

The optically anisotropic element G had been dipped in a 2 percent by mass potassium hydroxide aqueous solution at room temperature for 5 minutes to be saponified and washed in flowing water and dried. In accordance with the procedures of Example 1, on one surface of a polarizing element was laminated the optically anisotropic element G so that the liquid crystal polymer layer thereof is to be the outermost surface of the laminate, and on the other surface was laminated a saponified cellulose triacetate film thereby producing a circular polarizer H. The resulting circular polarizer H was subjected to ellipsometry using an ellipsometer (DVA-36VWLD manufactured by Mizojiri Optical Co., Ltd.) and was found to be 0.94 in ellipticity at a wavelength of 550 nm, thereby confirming that it was a circular polarizer with excellent circular polarization properties. As the result of the optical inspection of the circular polarizer H, it had many stains and scars that seemed to be caused by some damages on the liquid crystal polymer layer.

### [Comparative Example 3]

On both surfaces of a polarizing element that is a stretched polyvinyl alcohol adsorbing iodine was laminated via an acrylic adhesive saponified cellulose triacetate films thereby producing a polarizer. On this polarizer was continuously laminated via an acrylic tacky adhesive the optically anisotropic element B that have not been saponified so that the liquid crystal polymer layer is to be the outermost surface of the laminate thereby producing a circular polarizer I. The resulting circular polarizer I had a thickness of about 200 µm which was thick and thus increased the roll thickness and needed to be short in the length that can be processed per operation, compared with the production of the circular polarizer in Example 1. On the optically anisotropic element B of the circular polarizer I was laminated via an acrylic tacky adhesive a glass sheet. The same test as that in Example 1 was carried out. After the lapse of 500 hours, peeling off with a width of 0.5 mm was observed at edges.

### [Comparative Example 4]

A polarizer (thickness: 110 µm) prepared as in Comparative Example 3 using a 40 µm thick cellulose triacetate film was laminated with a 70 µm thickness uniaxial retardation film formed from polycarbonate (Δnd=137.5 nm) via a tacky adhesive layer with a thickness of about 25 µm thereby producing a circular polarizer J. A liquid crystal display device similar to that in Example 2 was produced using the circular polarizer J. In this device, the angle θ5 formed by the uniaxial retardation film and the polarizer 1 on the display side was 15 degrees (corresponding to θ6 = 0 degree), and the angle θ7 formed by the absorption axis of the polarizer 1 and that of the polarizer 4B was +60 degrees.

A driving voltage (1/240 duty, driven at the optimized bias) was applied from a driving circuit (not shown) to the electrodes 3B, 3C of the liquid crystal display, so as to examine the optical characteristics at the time the light is off (reflection mode) and on (transmission mode), respectively. It was confirmed that the display was rather low in contrast in the transmission mode and narrow in viewing angle properties. Further, the total thickness of the liquid crystal display was greater than that of Example 2.

### [Brief Description of the Drawings]

Fig. 1 is a vertical cross section view schematically illustrating the liquid crystal display device of Example 2.
Fig. 2 is a plan view showing the relationship of the absorption axes of the polarizers, and the axial angles of the liquid crystal cell, optical compensator and circular polarizer of the liquid crystal display device of Example 2.
Fig. 3 is a conceptual view of the liquid crystal display device used in Example 3.
Fig. 4 is a conceptual view of the organic EL display device used in Example 4.

### (Description of Numerals)

1: polarizer, 2: retardation compensator, 3: liquid crystal cell, 3A: liquid crystal layer, 3B: electrode, 3C: transflective electrode, 3D: substrate, 3E: sealant, 3F: alignment layer, 4: circular polarizer, 4A: optically anisotropic element, 4B: polarizer, 5: light diffusion tacky adhesive layer, 11: absorption axis of polarizer 1 on the viewer's side, 21: alignment axis of retardation compensator on polarizer 1 side, 22: alignment axis of retardation compensator on liquid crystal cell side,
31: alignment direction of liquid crystal layer 3A on polarizer 1 side,
32: alignment direction of liquid crystal layer 3A on polarizer 4 side,
41: alignment direction of optically anisotropic element 4A on liquid crystal cell 3 side,
42: alignment direction of optically anisotropic element 4A on polarizer 4B side,
43: absorption axis of polarizer 4B
6: upper polarizer, 7: liquid crystal cell, 8: lower polarizer, 9: 1/4 wavelength plate, 10: cellulose triacetate film, 11: cholesteric liquid crystal film, 12: brightness enhancement film, 13: light diffuser, 14: condenser sheet, 15: condenser sheet, 16: light diffuser, 17: light guide plate, 18: reflector, 19: lump, 20: back light, 21: polarizer, 22: 1/4 wavelength plate, 23: circular polarizer, 24: transparent glass sheet, 25: anode, 26: illuminant layer, 27: cathode, 28: organic EL device

## Claims

1. A circular polarizer comprising at least an optically anisotropic element, a transmissive protection film and a polarizing element sandwiched therebetween, the optically anisotropic element comprising a liquid crystal layer aligned on a cellulose triacetate film and having a retardation of approximately 1/4 wavelength in the visible light region, the liquid crystal layer comprising a liquid crystal film with a fixed twisted nematic alignment.

2. The circular polarizer according to claim 1, wherein the product of the birefringence Δn with respect to 550 nm wavelength light and the thickness d (nm) of the liquid crystal film is set within not less than 140nm and not greater than 300 nm, and the twisted angle is set within not smaller than 30 degrees and not greater than 85 degrees.

3. The circular polarizer according to claim 2, wherein the combination of the product of the birefringence Δn with respect to 550 nm wavelength light and the thickness d (nm) and the twisted angle of the liquid crystal film is set to satisfy any of the following conditions:
(1) not less than 155 nm and not greater than 175 nm, and not smaller than 40 degrees and not greater than 50 degrees;
(2) not less than 176 nm and not greater than 216 nm, and not smaller than 58 degrees and not greater than 70 degrees; and
(3) not less than 230nm and not greater than 270 nm, and not smaller than 70 degrees and not greater than 80 degrees.

4. The circular polarizer according to any one of claims 1 to 3, wherein the liquid crystal film is a liquid crystal film produced by allowing a liquid crystal material in a liquid crystal state to be aligned in a twisted nematic alignment and cooling the material as it is so that the alignment is fixed in a glassy state.

5. The circular polarizer according to any one of claims 1 to 3, wherein the liquid crystal film is a liquid crystal film produced by allowing a liquid crystal material in a liquid crystal state to be aligned in a twisted nematic alignment and fixing the alignment by crosslinking reaction with light or heat.

6. The circular polarizer according to any one of claims 1 to 5, wherein the thickness thereof is 250 µm or less.

7. The circular polarizer according to any one of claims 1 to 6, wherein the optically anisotropic element has been saponified.

8. The circular polarizer according to any one of claims 1 to 7, wherein a transmissive overcoat layer is provided on a surface of the liquid crystal layer.

9. The circular polarizer according to claim 8, wherein the transmissive overcoat layer is formed from an acrylic resin.

10. The circular polarizer according to any one of claims 1 to 9, wherein the alignment direction of the liquid crystal molecules near either one of the surfaces of the liquid crystal layer is not parallel to the machine direction.

11. The circular polarizer according to any one of claims 1 to 10, wherein the optically anisotropic element, transmissive protection film and polarizer are each in the form of an elongate film.

12. A process for producing the circular polarizer of any one of claims 1 to 11, comprising forming a liquid crystal layer on a cellulose triacetate film, arranging a transmissive overcoat layer on the surface of the liquid crystal layer to form an optically anisotropic element, saponifying the optically anisotropic element and laminating a polarizing element via an adhesive layer to be sandwiched between the optically anisotropic element and a transmissive protection film.

13. An optical film comprising the circular polarizer of any one of claims 1 to 11 and a cholesteric liquid crystal film.

14. A liquid crystal display device comprising the circular polarizer of any one of claims 1 to 11, arranged on at least one side of the liquid crystal cell.

15. A liquid crystal display device comprising the optical film of claim 13, arranged on at least one side of the liquid crystal cell.

16. An electroluminescence device comprising the circular polarizer of any one of claims 1 to 11.

17. The electroluminescence device according to claim 16, comprising a light diffusion layer arranged between the circular polarizer and an illuminant layer.
